# FASCICULE DE BREVET EUROPEEN

(11) **EP 0 972 304 B1**
(45) Date de publication et mention de la délivrance du brevet: **07.08.2002**
(21) Numéro de dépôt: 98904214.8
(22) Date de dépôt: 26.01.1998
(51) Int. Cl.: H01L 21/336, C30B 33/00, H01L 21/762

(54) **PROCEDE D'OBTENTION D'UN FILM MINCE, NOTAMMENT SEMICONDUCTEUR, COMPORTANT UNE ZONE PROTEGEE DES IONS, ET IMPLIQUANT UNE ETAPE D'IMPLANTATION IONIQUE**
EIN IONEN-IMPLANTIERUNGSSCHRITT VERVENDENTES VERFAHREN ZUR HERSTELLUNG VON EINEM-INSBESONDERE HALBLEITER- DÜNNSCHICHT MIT EINEM GEGEN IONEN GESCHÜZTE GEBIET
METHOD FOR OBTAINING A THIN FILM, IN PARTICULAR SEMICONDUCTOR, COMPRISING A PROTECTED ION ZONE AND INVOLVING AN ION IMPLANTATION

(30) Priorité: 27.01.1997 FR 9700837
(43) Date de publication de la demande: 19.01.2000
(73) Titulaire: COMMISSARIAT A L'ENERGIE ATOMIQUE, 75015 Paris (FR)
(72) Inventeur: BRUEL, Michel, F-38113 Veurey (FR); ASPAR, Bernard, F-38140 Rives (FR)
(74) Mandataire: Poulin, Gérard
(86) Numéro de dépôt international: FR9800129
(87) Numéro de publication internationale: WO9833209

(56) Documents cités:
- EP-A- 0 533 551
- EP-A- 0 660 140
- FR-A- 2 563 377
- "SOI INTERPOSER STRUCTURE" IBM TECHNICAL DISCLOSURE BULLETIN, vol. 39, no. 7, juillet 1996, pages 191-195, XP000627972
- "METHOD FOR FABRICATING A SELF-ALIGNED DUAL-GATE STRUCTURE ON AN SOI SUBSTRATE" IBM TECHNICAL DISCLOSURE BULLETIN, vol. 39, no. 7, juillet 1996, pages 163-167, XP000627963

## Description

### Domaine technique

La présente invention concerne un procédé d'obtention d'un film mince, comportant une zone protégée des ions, impliquant une étape d'implantation ionique. Elle concerne en particulier l'obtention d'un film mince semiconducteur dans lequel on a créé des couches actives, par exemple pour constituer des zones de canal de transistors MOS.

### Etat de la technique antérieure

Dans le domaine des semiconducteurs, on est quelquefois amené à réaliser des films minces de semiconducteurs, par exemple pour fabriquer des substrats dits "Silicium Sur Isolant". Différentes méthodes de réalisation de films minces semiconducteurs ont été développées. L'une des méthodes les plus récentes est basée sur le fait que l'implantation d'ions d'un gaz rare ou d'hydrogène dans un matériau semiconducteur induit la formation de zones fragilisées à une profondeur voisine de la profondeur moyenne de pénétration des ions. Le document FR-A-2 681 472 divulgue un procédé qui utilise cette propriété pour obtenir un film mince de matériau semiconducteur. Ce procédé consiste à soumettre une plaquette du matériau semiconducteur désiré et comportant une face plane aux étapes suivantes :
- une première étape d'implantation par bombardement de la face plane de la plaquette au moyen d'ions aptes à créer, dans le volume de la plaquette et à une profondeur voisine de la profondeur moyenne de pénétration des ions, une couche de "microbulles gazeuses" séparant la plaquette en une région inférieure constituant la masse du substrat et une région supérieure constituant le film mince, les ions étant choisis parmi les ions de gaz rares ou de gaz hydrogène ;
- une deuxième étape éventuelle de mise en contact intime de la face plane de la plaquette avec un support (ou raidisseur) constitué au moins d'une couche de matériau rigide, ce contact intime pouvant être réalisé par exemple à l'aide d'une substance adhésive, par l'effet d'une préparation préalable des surfaces et d'un traitement thermique ou/et électrostatique pour favoriser les liaisons interatomiques entre le support et la plaquette ;
- une troisième étape de traitement thermique de l'ensemble plaquette et support à une température supérieure à la température durant laquelle l'implantation a été effectuée et suffisante pour créer une séparation entre le film mince et la masse du substrat. Cette température est d'environ 400°C pour du silicium.

Dans ce document, on propose l'explication suivante aux différents phénomènes constatés par l'expérience. Tout d'abord, la première étape d'implantation ionique est menée en présentant à un faisceau d'ions une face plane d'une plaquette de matériau semiconducteur, le plan de cette face plane étant soit sensiblement parallèle à un plan cristallographique principal dans le cas où le matériau semiconducteur est parfaitement monocristallin, soit plus ou moins incliné par rapport à un plan cristallographique principal de mêmes indices pour tous les grains dans le cas où le matériau est polycristallin. Cette implantation est apte à créer une couche de microbulles gazeuses qui aboutira en fin de traitement thermique à une zone de fracture. Cette couche de microbulles créée ainsi dans le volume de la plaquette, à une profondeur voisine de la profondeur moyenne de pénétration des ions, délimite dans le volume de la plaquette deux régions séparées par cette couche : une région destinée à constituer le film mince et une région formant le reste du substrat. Par l'expression "microbulle gazeuse" on entend toute cavité ou microcavité générée par l'implantation d'ions de gaz hydrogène ou de gaz rares dans le matériau. Les cavités peuvent se présenter sous forme très aplatie, c'est-à-dire de faible hauteur, par exemple de l'ordre de quelques distances inter-atomiques, aussi bien que sous forme sensiblement hémisphérique ou sous tout autre forme différente des deux formes précédentes. Ces cavités peuvent ou non contenir une phase gazeuse. Au cours de la troisième étape, le traitement thermique est réalisé à une température suffisante pour créer, par effet de réarrangement cristallin dans le matériau semiconducteur tel que par exemple par effet de croissance des microcavités et/ou par effet de pression des microbulles, la zone de fracture et la séparation entre les deux régions.

Suivant les conditions d'implantation, après implantation d'un gaz comme par exemple l'hydrogène, des cavités ou microbulles sont observables ou non en microscopie électronique à transmission. Dans le cas du silicium, on peut avoir des microcavités dont la taille peut varier de quelques nm à quelques centaines de nm. Ainsi, en particulier lorsque la température d'implantation est faible, ces cavités ne sont observables qu'au cours de l'étape de traitement thermique, étape au cours de laquelle on réalise alors une nucléation grâce par exemple à une montée rapide en température pour permettre d'aboutir en fin de traitement thermique à la fracture entre le film mince et le reste du substrat.

En outre, il semble que ce procédé peut s'appliquer à tous les types de matériaux solides, cristallins ou non. Il est possible d'appliquer ce procédé à des matériaux diélectriques, conducteurs, semi-isolants, ainsi qu'à des matériaux semiconducteurs amorphes.

Il peut être intéressant que le film mince obtenu comporte certains éléments ou particularités qui ont été élaborés lorsque ce film faisait encore partie de son substrat initial. On peut ainsi réaliser une structure à trois dimensions par superposition de films minces. Dans le domaine de la microélectronique cela signifie que l'on peut obtenir des plaquettes, réalisées par empilement de films minces semiconducteurs, comportant des composants électroniques dans les trois dimensions de l'espace. Cependant, l'implantation d'ions au travers de couches électriquement actives peut créer des défauts qui modifient les caractéristiques des composants ou les rendent inutilisables. C'est le cas notamment des zones de canal et des couches d'oxyde de grille des transistors MOS.

IBM TDB 39(7), 191 (1996) et IBM TDB 39(7), 163 (1996) décrivent un procédé de fabrication d'une structure SOI dans lequel des ions sont implantés à travers une couche SOI.

### Expose de l'invention

Ainsi, le procédé divulgué par le document FR-A-2 681 472, qui est techniquement très intéressant, se trouvait limité dans certaines de ces applications. Il revient aux présents inventeurs d'avoir trouvé une solution à ce problème. Ils ont découvert que, sous certaines conditions, on peut utiliser une technique de masquage pour protéger les zones sensibles au passage des ions, ce qui implique une absence de microcavités dans les zones correspondant aux zones masquées, et obtenir malgré tout un clivage du substrat permettant d'en détacher un film mince. Ceci est possible si la largeur de chaque zone masquée ne dépasse pas une dimension limite déterminée pour le matériau constituant le substrat. Ce principe peut également être appliqué à des structures nécessitant la réalisation d'éléments avant l'implantation, ces éléments masquant des zones du substrat qui ne sont pas forcément sensibles à l'implantation. Dans ce cas, l'objet de l'invention est de réaliser ces éléments de largeur inférieure ou égale à la dimension limite.

L'invention a donc pour objet un procédé d'obtention d'un film mince à partir d'un substrat tel que décrit dans les revendications.

L'invention s'applique notamment au cas où le substrat semiconducteur est en silicium, où le composant électronique est un transistor MOS et où ladite zone inférieure est la couche d'oxyde de grille et la zone de canal de ce transistor MOS. La zone supérieure peut alors avantageusement comprendre la grille en polysilicium du transistor MOS déposée sur la couche d'oxyde de grille, ou même être constitués totalement par cette grille. En plus de la grille en polysilicium, les moyens de masquage peuvent comprendre une couche de résine ou d'autre matériau déposée sur les flancs de la grille. Un avantage important de ceci est que l'on peut obtenir des transistors de taille relativement grande puisque la largeur de la zone masquée ne correspond qu'à la largeur de la grille avec, éventuellement, ses flancs.

En procédant de la sorte, on peut être amené à réaliser l'implantation ionique dans un milieu hétérogène, par exemple dans le substrat semiconducteur et au travers de régions dopées constituant des zones de drain et de source. Ceci va à l'encontre de la pratique courante de l'homme du métier qui procède à un masquage complet des différentes régions actives d'un composant, c'est-à-dire incluant le drain et la source d'un transistor, avant de . réaliser l'implantation ionique. Les inventeurs de la présente invention ont découvert qu'en fait la zone d'un transistor qui est très sensible à une implantation ionique est la zone correspondant à l'oxyde de grille et non les zones de source et de drain. Une implantation ionique réalisée au travers des zones de source et de drain induit effectivement quelques perturbations dans les caractéristiques du transistor. Cependant, ces perturbations sont tout-à-fait admissibles pour le fonctionnement du transistor.

La grille du transistor servant de masque à la zone sensible lors de l'implantation, il n'est pas nécessaire d'inclure, dans le procédé d'obtention d'un film mince, une étape supplémentaire de masquage.

Il faut noter également que la constitution des régions de source et de drain peut très bien être effectuée après l'étape d'implantation ionique.

Le milieu dans lequel est réalisée l'implantation ionique peut également être constitué de matériaux différents, aussi bien dans une dimension parallèle au faisceau d'implantation que dans une direction qui lui est perpendiculaire. Ainsi, malgré l'hétérogénéité du milieu, on peut obtenir une fracture du substrat même avec des zones masquées au faisceau d'ions. Lorsqu'il existe une hétérogénéité de matériaux et/ou une hétérogénéité de la topologie de la surface du substrat, la fracture ne se propage pas uniquement dans un plan, mais l'on peut observer des ondulations en fonction des différences de position des ions implantés dues à une différence entre le pouvoir d'arrêt des différents matériaux vis-à-vis des ions.

### Brève description des dessins

L'invention sera mieux comprise et d'autres avantages et particularités apparaîtront à la lecture de la description qui va suivre, donnée à titre d'exemple non limitatif, accompagnée des figures annexées parmi lesquelles :
- la figure 1 est une vue de côté d'un substrat ayant subi une implantation d'ions,
- la figure 2 est une vue en coupe transversale d'un substrat de silicium où a été élaboré un transistor MOS et auquel est appliqué le procédé selon l'invention,
- les figures 3A à 3D illustrent l'application du procédé selon l'invention au transfert d'un film mince de silicium comportant un transistor MOS depuis son substrat initial jusqu'à un autre élément support.

### Description détaillée de modes de réalisation de l'invention

Pour simplifier la description, on considérera que l'implantation est réalisée dans des conditions telles que des microcavités sont observables après implantation et que le masquage est réalisé au-dessus d'une zone sensible à l'implantation.

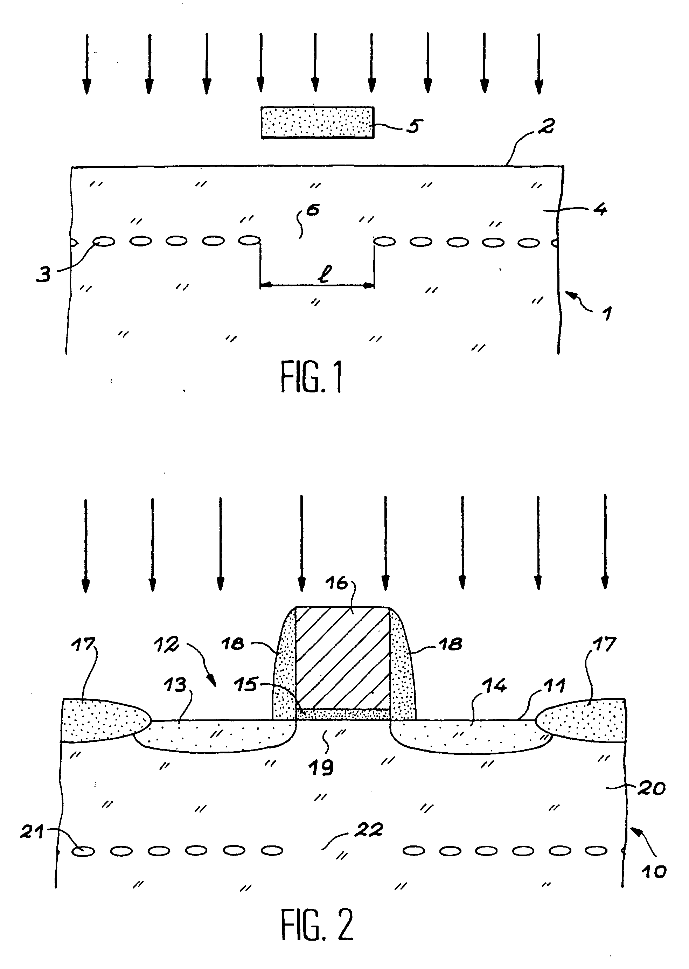

La figure 1 représente, en coupe transversale, un substrat 1 par exemple en silicium monocristallin de qualité électronique et possédant une face plane 2. Le substrat 1 est soumis, au travers de la face plane 2, à un bombardement ionique figuré par des flèches. Les ions implantés sont par exemple des protons. L'énergie fournie aux ions ainsi que leur dose est déterminée de façon à obtenir dans la masse du substrat 1 une couche de microcavités 3 située à une profondeur déterminée par rapport à la face plane 2. Le document FR-A-2 681 472 donne des indications sur l'énergie et la dose d'implantation d'ions pour obtenir une couche de microcavités à un niveau déterminé. La couche de microcavités 3 permet de délimiter dans le substrat une région 4. Un traitement thermique subséquent à une température appropriée, par exemple de l'ordre de 400°C, transforme la couche de microcavités en microfissures induisant une ligne de fracture permettant la séparation de la région 4, qui devient un film mince, du reste du substrat.

La figure 1 montre un masque 5 interposé entre le faisceau d'ions réalisant l'implantation ionique et la face 2 du substrat 1. Ce masque est d'épaisseur suffisante pour arrêter les ions qui l'atteignent. En conséquence, la couche de microcavités 3 est interrompue dans une zone 6 correspondant au masque 5 et la partie du substrat comprise entre la face plane 2 et la zone 6 n'est pas perturbée par l'implantation ionique.

Contrairement à ce que l'on pouvait penser, il est apparu que cette discontinuité dans la couche de microcavités n'empêche pas, dans certaines conditions, la propagation des microfissures dans la couche de microcavités lors de l'étape de traitement thermique. La propagation des microfissures dépend de la valeur de la largeur l de la zone masquée 6 à l'implantation.

A titre d'exemple, dans le cas d'un substrat en silicium monocristallin, si la largeur l de la zone masquée 6 est inférieure à 0,8 µm, la fracture peut se propager entre les microcavités situées de part et d'autre de la zone masquée. Si la largeur l de la zone masquée 6 est supérieure à 0,8 µm mais reste inférieure à une largeur limite déterminée, la propagation de la fracture peut être obtenue par l'intermédiaire de forces mécaniques, par exemple de flexion ou de traction, appliquées entre la région 4 et le reste du substrat de manière à les séparer, lors du traitement thermique ou après celui-ci, sans altérer mécaniquement le film mince obtenu.

La largeur limite, pour un matériau de substrat déterminé, est donc la largeur maximale d'une zone masquée qui permet un détachement du film mince sans altération mécanique préjudiciable de ce film. Cette largeur limite dépend également de la taille et de la densité des fissures induites dans le substrat et donc des paramètres qui déterminent ces fissures (énergie et dose d'implantation, température du traitement thermique).

Il est à noter que cette largeur l, qui correspond à la largeur de la zone masquée, peut être sensiblement différente de la largeur sur laquelle des microcavités sont absentes. En effet, dans le cas d'une implantation ionique, le faisceau n'est pas parfaitement parallèle mais est, suivant les conditions d'implantation, convergent ou divergent. De plus, la position d'un ion implanté dans un matériau présente un caractère aléatoire et statistique qui dépend de la succession de collisions que l'ion a rencontré. Par exemple, dans le cas de l'hydrogène implanté, à 120 keV dans du silicium amorphe, la déviation standard latérale telle que définie et calculée dans les Tables Gibbons atteint 0,2596 µm.

Dans l'exemple représenté à la figure 2, le substrat 10 est une plaquette de silicium monocristallin dopé p. Sur une face plane 11 de ce substrat, on a élaboré un transistor MOS 12. Ce transistor 12 comporte une source 13 constituée par une région dopée n⁺ et un drain 14 constitué également par une région dopée n⁺. Sur la face 11 du substrat et entre la source 13 et le drain 14, une couche d'oxyde de silicium 15 a été formée. La couche d'oxyde 15 a été recouverte d'une grille 16 en silicium polycristallin. Le transistor 12 a été complété en l'entourant d'une couche 17 d'oxyde thermique et en prévoyant des espaceurs 18 en nitrure de silicium sur les flancs de la grille 16.

La couche d'oxyde de grille 15 et la zone de canal 19 sous-jacente constituent une zone sensible puisque ces couches peuvent être perturbées par le passage des espèces implantées. Selon la présente invention, cette zone sensible peut être protégée, lors de l'étape d'implantation ionique par la grille 16 qui les recouvre, cette grille étant suffisamment épaisse pour empêcher que les ions implantés n'atteignent la couche d'oxyde 15. Les espaceurs peuvent également participer à cette protection.

L'étape d'implantation ionique a été figurée par des flèches sur la figure 2. L'implantation ionique a induit une couche de microcavités 21, délimitant une région 20 correspondant au film mince, et possédant une discontinuité constituée par la zone 22 masquée au faisceau d'ions. Comme il a été dit plus haut, si la largeur de la zone masquée est inférieure à la largeur limite résultant du matériau semiconducteur et des conditions d'implantation et de traitement thermique, le film mince 20 peut être séparé du substrat avec ou sans forces mécaniques appliquées en fonction de la valeur de la largeur de la zone 22. Par exemple, une grille 16 de 0,5 µm de largeur n'empêche pas la propagation des microfissures dans le plan de fracture dans des conditions de mise en oeuvre habituelles du procédé divulgué dans le document FR-A-2 681 472.

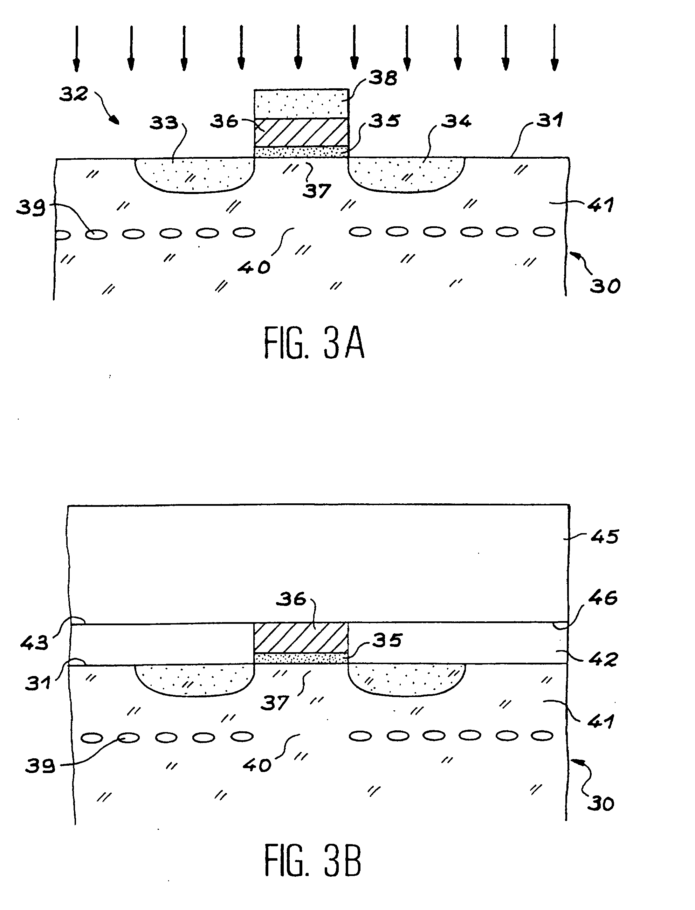

Les figures 3A à 3D illustrent une variante d'application du procédé selon la présente invention. Ces figures sont aussi des vues en coupe transversale comme pour la figure 2.

La figure 3A montre un substrat 30 en silicium monocristallin dopé p. Sur la face plane 31 de ce substrat, un transistor MOS 32 a été élaboré. Le transistor MOS comporte des régions de source 33 et de drain 34 dopées n⁺, une couche d'oxyde de grille 35, une grille en silicium polycristallin 36 et une zone de canal 37. Dans cette variante, il a été jugé nécessaire de déposer une couche de résine 38 sur la grille 36 afin d'assurer un bon masquage de la zone sensible du transistor MOS. L'implantation ionique figurée par des flèches provoque la création une couche de microcavités 39 dans la masse du substrat à l'exception de la zone 40 masquée à l'implantation ionique. La largeur de cette zone masquée, correspondant à la largeur de la grille 36, est inférieure à la largeur limite permettant la mise en oeuvre du procédé selon la présente invention. On a ainsi défini, entre la face plane 31 et la couche de microcavités 39, une région 41 destinée à former le film mince.

Une fois terminée l'étape d'implantation ionique, la couche de résine 38 est enlevée et une couche 42 d'oxyde SiO₂ est formée sur la face plane 31 du substrat 30, jusqu'au niveau supérieur de la grille 36 afin d'obtenir une surface plane 43 qui constituera la face supérieure du film mince (voir la figure 3B). Une plaque 45, jouant le rôle de raidisseur et possédant une face plane 46 est rendue solidaire de la face supérieure du film mince. Cette solidarisation peut être obtenue par exemple par collage des faces planes 43 et 46 entre elles ou par la technique dénommée "Wafer Bonding", c'est-à-dire par collage par adhésion moléculaire.

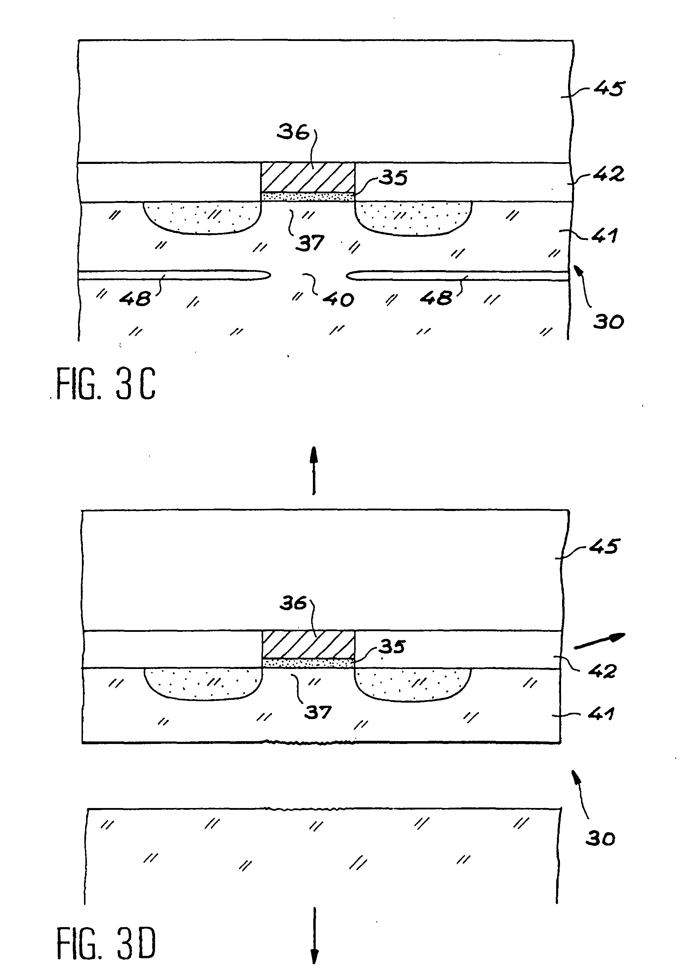

La figure 3C montre la structure composite réalisée précédemment après l'étape de traitement thermique. Comme il a été dit-plus haut, cette étape de traitement thermique a pour conséquence de transformer la couche de microcavités en microfissures. On peut alors obtenir soit une ligne de fracture continue si la largeur de la zone masquée est suffisamment petite par rapport à la largeur limite précédemment définie, soit une ligne de fracture discontinue si la largeur de la zone masquée n'est pas assez petite par rapport à la largeur limite. C'est ce dernier cas qui est montré à la figure 3C où la ligne de microfissures 48 est interrompue dans la zone masquée 40.

La séparation du substrat en deux parties de part et d'autre de la ligne de microfissures s'obtient alors par application de forces mécaniques. C'est ce que montre la figure 3D où les forces mécaniques sont symbolisées par des flèches.

## Revendications

1. Procédé d'obtention d'un film mince à partir d'un substrat semiconducteur (10;30), ce film mince étant constitué par une région (20;41) du substrat adjacente à l'une (11;31) de ses faces et séparée du reste du substrat, au moins un transistor étant élaboré à partir de ladite région, le procédé comprenant les étapes suivantes :
- élaboration dudit transistor jusqu'à obtenir au moins deux zones superposées et constitutives du transistor, la zone supérieure (16,36), comprenant la grille du transistor, servant de moyens de masquage à la zone inférieure (15,19 ; 35,37) en définissant une largeur de zone masquée (22;40) dans le substrat qui ne dépasse pas une dimension limite déterminée pour le matériau dudit substrat,
- implantation ionique du substrat (10;30) au travers de ladite face du substrat apte à créer, dans le volume du substrat et à une profondeur voisine ce la profondeur moyenne de pénétration des ions, une couche de microcavités (21;39) délimitant ladite région (20;41) du reste du substrat (10;30) à l'exception d'une zone correspondant à la zone masquée (22;40),
- traitement thermique à une température suffisante pour réaliser une ligne de fracture au niveau de cette couche de microcavités, cette ligne de fracture étant soit continue si la largeur de la zone masquée est suffisamment petite par rapport à ladite dimension limite, soit discontinue si la largeur de la zone masquée n'est pas assez petite par rapport à ladite dimension limite,
- séparation du film mince du reste du substrat (10;30) soit par simple écartement si la ligne de fracture est continue, soit par l'application de forces mécaniques entre ladite région et le reste du substrat si la ligne de fracture est discontinue.

2. Procédé selon la revendication 1, **caractérisé en ce que**, entre l'étape d'implantation ionique et l'étape de traitement thermique, il est prévu une étape où le substrat (30) est rendu solidaire, du côté de ladite région (41) devant constituer le film mince, avec un raidisseur (45).

3. Procédé selon l'une des revendications 1 ou 2, **caractérisé en ce que** l'implantation ionique est réalisée au moyen d'ions hydrogène ou d'ions de gaz rares.

4. Procédé selon l'une quelconque des revendications 1 à 3, **caractérisé en ce que** lesdites forces mécaniques sont des forces de flexion et/ou de traction.

5. Procédé selon l'une quelconque des revendications 1 à 4, **caractérisé en ce que** lesdites forces mécaniques sont appliquées pendant l'étape de traitement thermique.

6. Procédé selon l'une quelconque des revendications 1 à 4, **caractérisé en ce que** lesdites forces mécaniques sont appliquées après l'étape de traitement thermique.

7. Procédé selon l'une quelconque des revendications 1 à 6, **caractérisé en ce que** les moyens de masquage sont constitués par une couche déposée sur ladite face du substrat.

8. Procédé selon l'une quelconque des revendications 1 à 7, **caractérisé en ce que**, le substrat (10;30) étant en silicium, le transistor (12;32) étant un transistor MOS et ladite zone inférieure étant la couche d'oxyde de grille (15;35) et la zone de canal (19;37) de ce transistor MOS, la zone supérieure comprend la grille (16;36) en polysilicium du transistor MOS déposée sur la couche d'oxyde de grille (15;35).

9. Procédé selon l'une quelconque des revendications 1 à 8, **caractérisé en ce que** les moyens de masquage comprennent également une couche de résine (38).

10. Procédé selon l'une quelconque des revendications 1 à 9, **caractérisé en ce que** les moyens de masquage comprennent également des espaceurs (18) déposés sur les flancs de la grille (16).

## Patentansprüche

1. Verfahren zur Herstellung einer Dünnschicht, ausgehend von einem Halbleitersubstrat (10;30), wobei diese Dünnschicht durch einen Bereich (20;41) des Substrats gebildet wird, der an eine (11;31) seiner Seiten angrenzt, und vom Rest des Substrats abgetrennt wird, wobei aus dem genannten Bereich wenigstens ein Transistor hergestellt wird und das Verfahren dabei die folgenden Schritte umfasst:
- Herstellung des genannten Transistors, bis man wenigstens zwei übereinanderliegende und konstitutive Zonen des Transistors erhält, wobei die obere Zone (16,36), das Gate des Transistors umfassend, als Maskiereinrichtung für die untere Zone (15,19; 35,37) dient, indem sie in dem Substrat eine maskierte Zonenbreite (22;40) definiert, die eine für das Material des genannten Substrats festgelegte Grenzabmessung nicht überschreitet,
- lonenimplantierung des Substrats (10;30) durch die genannte Fläche bzw. Seite des Substrats hindurch, fähig in dem Volumen des Substrats und in ungefähr einer der mittleren Eindringtiefe der lonen entsprechenden Tiefe eine Schicht aus Mikrohohlräumen oder -blasen (21;39) zu schaffen, die den genannten Bereich (20;41) vom Rest des Substrats (10;30) trennt, mit Ausnahme einer der maskierten Zone (22;40) entsprechenden Zone,
- Wärmebehandlung bei einer Temperatur, die ausreicht, um in Höhe dieser Mikroblasenschicht eine Bruchlinie zu realisieren, wobei diese Bruchlinie entweder durchgehend ist, wenn die Breite der maskierten Zone ausreichend klein ist in Bezug auf die genannte Grenzabmessung, oder nicht durchgehend, wenn die Breite der maskierten Zone nicht ausreichend klein ist in Bezug auf die genannte Grenzabmessung,
- Trennung der Dünnschicht vom Rest des Substrats (10;30), entweder durch einfaches Entfernen, wenn die Bruchlinie durchgehend ist, oder durch das Anwenden mechanischer Kräfte zwischen dem genannten Bereich und dem Rest des Substrats, wenn die Bruchlinie nicht durchgehend ist.

2. Verfahren nach Anspruch 1, **dadurch gekennzeichnet, dass** zwischen dem lonenimplantationsschritt und dem Wärmebehandlungsschritt ein Schritt vorgesehen ist, in dem das Substrat (30) auf der Seite des genannten Bereichs (41), der die Dünnschicht bilden soll, fest mit einem Versteifungselement (45) verbunden wird.

3. Verfahren nach einem der Ansprüche 1 oder 2, **dadurch gekennzeichnet, dass** die lonenimplantation mittels Wasserstoff-lonen oder Seltenerdengas-lonen realisiert wird.

4. Verfahren nach einem der Ansprüche 1 bis 3, **dadurch gekennzeichnet, dass** die genannten mechanischen Kräfte Biege- und/oder Zugkräfte sind.

5. Verfahren nach einem der Ansprüche 1 bis 4, **dadurch gekennzeichnet, dass** die genannten mechanischen Kräfte während des Wärmebehandlungsschritts angewendet werden.

6. Verfahren nach einem der Ansprüche 1 bis 4, **dadurch gekennzeichnet, dass** die genannten mechanischen Kräfte nach dem Wärmebehandlungsschritt angewendet werden.

7. Verfahren nach einem der Ansprüche 1 bis 6, **dadurch gekennzeichnet, dass** die Maskiereinrichtungen durch eine Schicht gebildet werden, die auf der genannten Fläche bzw. Seite des Substrats abgeschieden wird.

8. Verfahren nach einem der Ansprüche 1 bis 7, **dadurch gekennzeichnet, dass** das Substrat (10;30) aus Silicium ist, der Transistor (12;32) ein MOS-Transistor ist und die genannte untere Zone die Gateoxidschicht-Zone (15;35) und die Kanalzone (19;37) dieses MOS-Transistors ist, wobei die obere Zone das Gate (16;36) des MOS-Transistors aus Polysilicium ist, abgeschieden auf der Gateoxidschicht (15;35).

9. Verfahren nach einem der Ansprüche 1 bis 8, **dadurch gekennzeichnet, dass** die Maskiereinrichtungen auch eine Resistschicht (38) umfassen.

10. Verfahren nach einem der Ansprüche 1 bis 9, **dadurch gekennzeichnet, dass** die Maskiereinrichtungen auch Spacer (18) umfassen, abgeschieden auf den Flanken des Gates (16).

## Claims

1. Process for obtaining a thin film from a semiconductor substrate (10, 30), said thin film being constituted by a region (20, 41) of the substrate adjacent to one (11, 31) of its faces and separated from the remainder of the substrate, at least one transistor being produced from said region, the process comprising the following steps:
- production of said transistor until there are at least two superimposed zones constituting the transistor, the upper zone (16, 36), comprising the transistor gate, serving as masking means for the lower zone (15, 19; 35, 37) defining a masked zone width (22, 40) in the substrate not exceeding a given, limit dimension for the material of said substrate,
- ion implantation of the substrate (10, 30) through said substrate face able to create, in the volume of the substrate and at a depth close to the mean ion penetration depth, a microcavity layer (21, 39) delimiting said region (20, 41) from the remainder of the substrate (10, 30) with the exception of a zone corresponding to the masked zone (22, 40),
- heat treatment at an adequate temperature for bringing about a fracture line at said microcavity layer, said fracture line either being continuous if the masked zone width is sufficiently small compared with said limit dimension, or discontinuous if the masked zone width is not sufficiently small compared with said limit dimension,
- separation of the thin film from the remainder of the substrate (10, 30) either by simply moving away if the fracture line is continuous, or by the application of mechanical forces between said region and the remainder of the substrate if the fracture line is discontinuous.

2. Process according to claim 1, **characterized in that**, between the ion implantation step and the heat treatment step, there is a step where the substrate (30) is rendered integral, from the side of said region (41) which is to form the thin film, with a stiffener (45).

3. Process according to one of the claims 1 or 2, **characterized in that** ion implantation takes place by means of hydrogen or rare gas ions.

4. Process according to any one of the claims 1 to 3, **characterized in that** said mechanical forces are bending and/or tensile forces.

5. Process according to any one of the claims 1 to 4, **characterized in that** said mechanical forces are applied during the heat treatment step.

6. Process according to any one of the claims 1 to 4, **characterized in that** said mechanical forces are applied after the heat treatment step.

7. Process according to any one of the claims 1 to 6, **characterized in that** the masking means are constituted by a layer deposited on said substrate face.

8. Process according to any one of the claims 1 to 7, **characterized in that** with the substrate (10, 30) being made from silicon, the transistor (12, 32) being a MOS transistor and said lower zone being the gate oxide layer (15, 35) and the channel zone (19, 37) of said MOS transistor, the upper zone comprises the polysilicon gate (16, 36) of the MOS transistor deposited on the gate oxide layer (15, 35).

9. Process according to any one of the claims 1 to 8, **characterized in that** the masking means also comprise a resin layer (38).

10. Process according to any one of the claims 1 to 9, **characterized in that** the masking means also comprise spacers (18) deposited on the flanks of the gate (16).
